Europäisches Patentamt

European Patent Office

Office européen des brevets

(19)

(11) **EP 1 693 965 A1**

(12) **EUROPEAN PATENT APPLICATION**

(43) Date of publication:
**23.08.2006 Bulletin 2006/34**

(51) Int Cl.:
*H03K 23/42* (2006.01)     *H03K 23/54* (2006.01)
*H03L 7/183* (2006.01)     *H03L 7/099* (2006.01)

(21) Application number: **05101333.2**

(22) Date of filing: **22.02.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(71) Applicant: **STMicroelectronics S.r.l.**
**20041 Agrate Brianza (Milano) (IT)**

(72) Inventors:
• **Tonietto, Riccardo**
  **29100 PIACENZA (PC) (IT)**
• **Radice, Francesco**
  **22070, CAPIAGO (CO) (IT)**

(74) Representative: **Pezzoli, Ennio et al**
**Maccalli & Pezzoli S.r.l.**
**Via Settembrini 40**
**20124 Milano (IT)**

(54) **Six phases synchronous by-4 loop frequency divider**

(57)     A frequency divider circuit (108) for obtaining, from a plurality of first signals (ck0,ck60,ck120,ck180,ck240,ck300) having a first frequency (Fo) and being out-of-phase to each other, at least one second signal (Vd) having a second frequency (Fd) equal to a fraction of the first frequency. The frequency divider circuit includes a delaying block (F1,F2,F3) for each first signal, the delaying blocks being series-connected in a closed loop and having a signal input (D1,*D1; D2,*D2; D3,*D3), a signal output (Q1,*Q1; Q2,*Q2; Q3,*Q3) connected to the signal input of a next delaying block in the closed loop, and a clock input (C1,*C1; C2,*C2; C3,*C3) for receiving the corresponding first signal. Each second signal is taken from the signal output of a corresponding delaying block.

EP 1 693 965 A1

**Description**

The present invention relates to the signal synthesis field. More specifically, the present invention relates to the frequency division of multiphase signals.

The synthesis of different signals is commonplace in several applications. A typical example is the generation of multiphase clock signals by means of a Phase Locked Loop (PLL). The purpose of multiphase clock synthesizers based on PLL structures is the generation of a high frequency clock signal with several phases (ideally evenly spaced in time), starting from a low frequency single phase reference clock. Typical applications of such PLLs are the internal base generation in oversampling data recovery circuits, and the clock data recovery in hard-disks and optics-fiber systems.

The core of the above-described PLLs is an N-phases Voltage Controlled Oscillator (VCO), which can be realized either with an inverter based ring oscillator, or with an LC tank based ring oscillator; both consist of N single ended, or N/2 differential, identical stages connected in a ring.

Multiphase VCOs are very sensitive to any asymmetry among the oscillator stages composing the ring (especially in the case of LC tank based VCOs, where high quality factor Q resonators are used). Asymmetry of oscillator stages translates in an uneven time spacing among the generated clock signals, and then in a systematic phase error with respect to the ideal condition. The ratio between the maximum time error and the ideal time interval between two adjacent clock signals (referred to as phase accuracy) is a crucial parameter in determining multiphase PLLs performance.

As a consequence, a particular attention to an N-symmetrical implementation, both in schematic design and layout, needs to be addressed for the PLL core, that is the VCO itself. Similar considerations also apply to output buffers and to a frequency divider, which are directly connected to the oscillator stages. Particularly, the frequency divider is usually implemented in two parts: a synchronous high frequency divider, with a dividing ratio of 2 or 4, followed by an asynchronous low frequency divider with higher dividing ratio; the input transistors of the high frequency divider are directly connected to the oscillating nodes of the VCO.

A dividing ratio of 4 is frequently needed for the high frequency divider when the synthesized clock signals are in the multi-GHz range, in such a way that the by-4 divided frequency is low enough to properly drive a CMOS asynchronous low frequency divider to accomplish the desired division.

Typically, for the synchronous high frequency divider, a cascade of two CML (Current-Mode-Logic) master-slave flip-flops (each one configured as a by-2 divider) are used, where only the first by-2 divider is intrinsically synchronous and the second one is retimed by the VCO; this is done because synchronous by-4 dividers with single ring architecture can have a forbidden operating mode in which a wrong division ratio is obtained.

Frequency dividers and buffers are directly connected to the VCO but, while N phases intrinsically require N output buffers, the divider needs to operate only over one phase and a natural N-symmetrical implementation would be redundant and therefore power consuming.

If only one phase of the VCO is connected to the frequency divider, dummies are used to preserve oscillator stages load. Existing examples of multiphase PLLs mainly employ passive or active dummies.

Passive dummies consist of non-biased replica of the input stage of the high frequency divider that can be, depending on the frequency divider topology, a variable number of MOS transistors. For example, in CML-like implementations the input of a by-2 divider consists of two MOS transistor gates for each phase. Each one of the N-1 oscillator stages not connected to any frequency divider is connected to one dummy, so that each stage is loaded with a fixed capacitance whose value is close to the DC capacitance of the frequency divider input stage which is connected to the remaining oscillator stage.

The main drawback of this solution consists in that such fixed value of capacitive load degrades the phase accuracy.

In a similar way active dummies consist of N-1 biased replica of the divider input transistors, in such a way that again each oscillator stage is loaded with the full capacitance equal, now also for large signal working conditions, to the one of the active divider.

In this case a capacitance equivalent to the divider input stage load is fully added to each stage, increasing the total oscillator stage capacitance; this reduces the tuning range of the VCO in case of an LC tank based architecture, or limits the size, and thus the matching, of the inverters in a classical ring oscillator implementation. A further drawback of using active dummies is the significant waste of power, since usually the high frequency divider is biased with high current, often in the order of magnitude of the VCO stages biasing, for achieving high frequency of operation.

The present invention propose a solution for the implementation of a frequency divider suitable to be used in multiphase PLLs without the need of any dummy.

Particularly, an aspect of the present invention provides a frequency divider circuit for obtaining, from a plurality of first signals having a first frequency and being out-of-phase to each other, at least one second signal having a second frequency equal to a fraction of the first frequency. Said frequency divider circuit includes a delaying block for each first signal. The delaying blocks are series-connected in a closed loop and have a signal input, a signal output connected to the signal input of a next delaying block in the closed loop, and a clock input receiving the corresponding first signal.

Each second signal is taken from the signal output of a corresponding delaying block.

In this way, the division of the desired signal(s) is performed directly with a single closed loop structure.

At the same time, the synthesis is accomplished without using any dummy connected to the VCO.

Consequently, this solution does not imply any extra power consumption due to the presence of dummies.

Moreover, the capacitance that loads each stage of the VCO is divided among the stages, thus reducing the total load capacitance seen by the same VCO.

The preferred embodiments of the invention described in the following provide additional advantages.

For example, according to an embodiment of the present invention, the phase difference between the first signals of each pair of adjacent delaying blocks is equal to $2\Phi$ radians divided by a number of the delaying blocks and multiplied by a predetermined factor (wherein said fraction is equal to twice said factor).

According to an embodiment of the invention, the frequency divider consists of three delaying blocks.

In a preferred embodiment of the present invention said factor is equal to two.

Preferably, each delaying block includes a master-slave flip-flop.

According to an embodiment of the present invention, the flip-flops have a differential structure.

Another aspect of the present invention provides a phase-locked-loop circuit including the frequency divider described above.

In a preferred embodiment of the present invention, the phase-locked-loop circuit includes a further frequency divider for dividing the frequency of the at least one second signal.

Preferably, the at least one second signal consists of a single second signal.

Another aspect of the present invention provides a corresponding frequency division method.

The characterizing features of the present invention are set forth in the appended claims. The invention itself, however, as well as further features and advantages thereof will be best understood by reference to the following detailed description, given purely by way of a non-restrictive indication, to be read in conjunction with the accompanying drawings:

Figure 1 illustrates a functional block-diagram of a multiphase PLL in which the solution according to an embodiment of the present invention is applicable;
Figure 2 details an exemplary multiphase VCO of the PLL;
Figure 3 illustrates a frequency divider of the PLL according to an embodiment of the present invention; and
Figure 4 illustrates a simplified time diagram showing an exemplary temporal evolution of signals generated by the frequency divider.

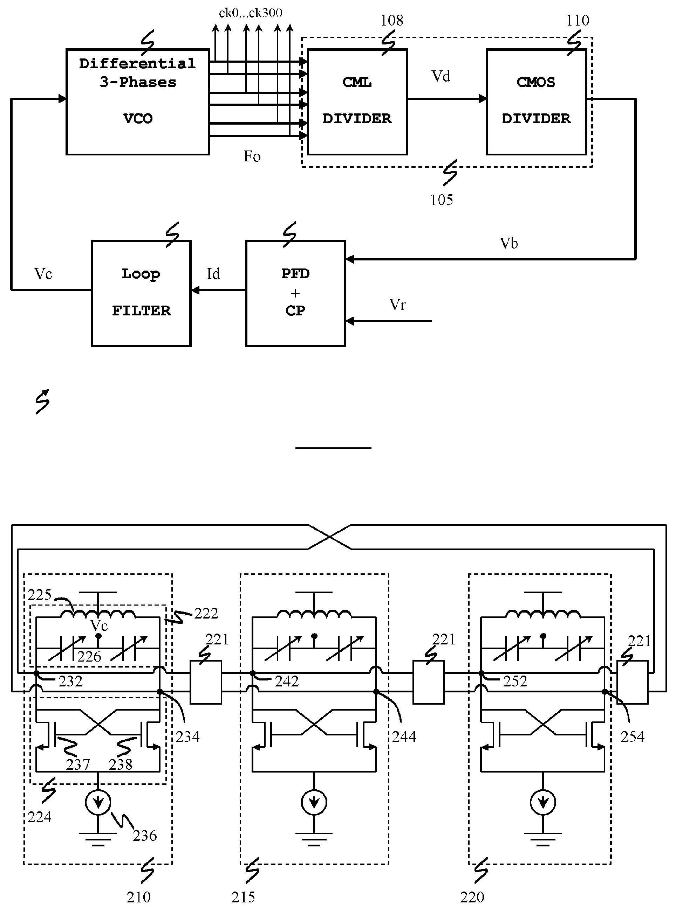

With reference in particular to Figure 1, a digital PLL 100 is shown. The PLL 100 is used to synthesise six clock signals ck0, ck60, ck120, ck180, ck240, ck300 with a desired high frequency Fo (e.g., of several GHz), and with phases ideally evenly spaced in time (with a phase difference $\Phi\Phi=(2/3)2\pi$ in this case), starting from a low frequency single phase reference clock signal Vr. The desiderated high frequency Fo for the clock signals ck0-ck300 is obtained multiplying a frequency Fr of the reference clock signal Vr by a selected conversion factor N; the reference clock signal Vr is generated by a quartz oscillator (not shown in the figure), which provides a stable and accurate time base.

The PLL 100 implements a feedback loop through a frequency divider 105 that receives the clock signals ck0-ck300. The frequency divider 105 includes two blocks that are series-connected: a high frequency divider 108 (realized in CML (Current-Mode-Logic) technology), and a low frequency divider 110 (realized in CMOS (Complementary Metal Oxide Semiconductor) technology). The element 108 is a synchronous high frequency divider, with a dividing ratio of, e.g., four. The high frequency divider 108 receives the clock signals ck0-ck300 with the high frequency Fo, and provides a divided signal Vd of frequency Fd (with Fd=F0/4 in this example) to the low frequency divider 110. The element 110 is an asynchronous low frequency divider with higher dividing ratio, which provides a feedback signal Vb having a frequency Fb. The frequency Fb of the feedback signal Vb is related to the one of the clock signals ck0-ck300, that is Fo, in this way: Fb=Fo/N. The conversion factor N is therefore equal to the product of the dividing ratios of the high frequency divider 108 and of the low frequency divider 110. The feedback signal Vb is fed back to a phase comparator 115.

The block 115 compares the feedback signal Vb with the reference clock signal Vr. The phase comparator 115 outputs a control current Id indicative of the phase difference between the two signals, which current Id is injected into a loop filter 120. The loop filter 120 removes the high frequency components of the control current Id; moreover, it integrates the control current Id into a corresponding voltage Vc. The control voltage Vc drives a multi-phase Voltage Controlled Oscillator (VCO) 125, which provides the clock signals ck0-ck300 accordingly. Said clock signals ck0-ck300 are also made available to the outside of the PLL 100 by means of driver circuits that are not shown in the Figure.

During operation of the PLL 100, the VCO 125 starts oscillating at a free-run frequency as a consequence of background noise in the circuit. The frequency divider 105 divides the frequency Fo of the output signal Vo by N, so that Fb=Fo/N.

In an unlock condition (such as during an initial power up or immediately after a channel switching), the frequency Fb of the feedback signal Vb is different from the frequency Fr of the reference signal Vr. Therefore, the phase comparator 115 outputs a corresponding control current Id. The resulting control voltage Vc (from the loop filter 120) changes the frequency Fo of the clock signals ck0-ck300 accordingly. Particularly, when the feedback frequency Fb is lower than the reference frequency Fr, the control voltage Vc instructs the VCO 125 to increase the frequency Fo; conversely, when the feedback frequency Fb is higher than the reference frequency Fr, the control voltage Vc instructs the VCO 125 to reduce the frequency Fo.

After a transient period, the frequency Fb of the feedback signal Vb reaches the frequency Fr of the reference signal Vr (with Vc=0). In this lock condition, the frequency Fo of the clock signals ck0-ck300 is thus equal to Fr*N.

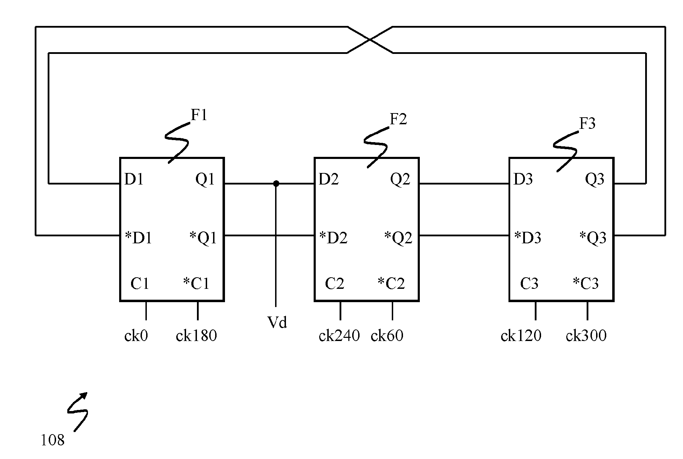

With reference now to Figure 2, the structure of the VCO 125 is illustrated. In the example at issue, the VCO 125 is of a six phases (three differential) LC tank ring type. The VCO 125 consists of three equal differential stages 210, 215, 220 connected in a closed loop by means of couplers 221, indispensable for guarantying a good quality factor of the clock signals generated, as it will be more clear later on. For the detailed description of the VCO 125, reference will be made to the stage 210, responsible of the generation of the clock signal ck0 and of the clock signal ck180 (similar considerations apply to the other stages 215 and 220).

The differential stage 210 includes an LC tank 222 and a negative transconductance amplifier 224. The LC tank 222 is composed by a shunt-connection between an inductor 225 (with an inductance equal to L) and a varactor 226 (with a variable capacitance equal to C). Said shunt-connection forms two circuital nodes 232 and 234, wherein the clock signals ck0 (node 232) and ck180 (node 234) are made available. The resonant frequency of the LC tank 222 is given by $Fo=1/(2\pi(LC)^{1/2})$. The tuning capability of the LC tank 222 is provided by the varactor 226, that exhibits a voltage dependant capacitance C; for this purpose, the varactor 226 includes a terminal for receiving the control voltage Vc. By controlling the capacitance C via the control voltage Vc, the resonant frequency Fo (and thus, the frequency of the clock signals ck0 and ck180) can be updated (so that the PLL can stabilize and lock at the frequency Fr of the reference signal Vr). The energy losses of the LC tank 222 are compensated by the negative transconductance amplifier 224, which is supplied by a current generator 236 and realized by means of a cross-coupled differential pair (formed by two NMOS transistors 237,238). More particularly, the source terminals of both the NMOS transistors 237, 238 are connected to a terminal of the current generator 236 (another terminal of the current generator 236 is connected to a terminal providing a ground voltage); the drain terminal of the NMOS transistor 237 is connected to the node 232, and the drain terminal of the NMOS transistor 238 is connected to the node 234. Finally, the gate terminal of the NMOS transistor 237 is connected to the node 234, while the gate terminal of the NMOS transistor 238 is connected to the node 232. Said negative transconductance amplifier 224 acts as a negative resistor thanks to its positive feedback.

According to the differential structure of the stage 210, the two clock signals ck0 and ck180 are in phase-opposition, that is, they have a phase difference of $\Phi$ radians.

The node 232 is connected to the corresponding node in the stage 215 (node 242) by means of a coupler 221. In the same way, the node 234 is connected to the corresponding node in the stage 215 (node 244). The couplers 221 avoid that the LC tank of a stage would interact with the one of an adjacent stage, in such a way to obtain clock signals with precise frequency and correct phase. Similarly, the node 242 is connected to the corresponding node in the stage 220 (node 252) and the node 244 is connected to the corresponding node in the stage 220 (node 254) by means of a coupler 221. Differently, according to a cross-connection, the node 252 is connected to the node 234 of the stage 210, and the node 254 is connected to the node 232 of the stage 210 (both of them by means of a coupler 221).

Thanks to the closed-loop configuration and to the presence of the couplers 221, the VCO 125 is in position to generate six clock signals with phases ideally evenly spaced in time. More particularly, taking the clock signal ck0 synthesized at the node 232 as a phase reference, the clock signal ck180 synthesized at the node 234 has a phase difference of 180 degrees with respect to the clock signal ck0, the clock signal ck240 synthesized at the node 242 has a phase difference of 240 degrees with respect to the clock signal ck0, the clock signal ck120 synthesized at the node 252 has a phase difference of 120 degrees with respect to the clock signal ck0, and so on.

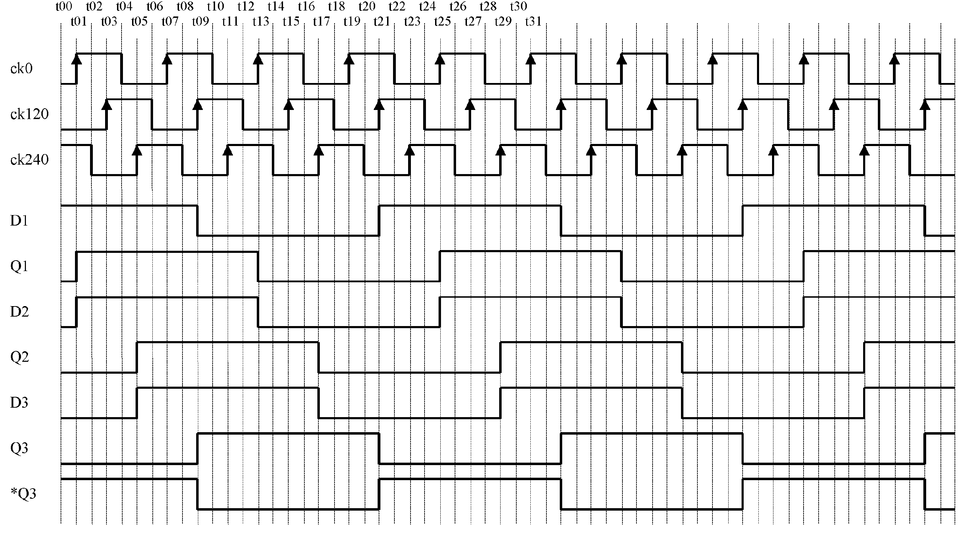

Turning now to Figure 3, a more detailed scheme of the high frequency divider 108 is illustrated. The high frequency divider 108 includes three equal differential master-slave flip-flops of the CML type F1, F2, F3. Referring in particular to the flip-flop F1, it includes an input terminals D1 and a complementary input terminal *D1. Said terminals D1 and *D1 are adapted to receive logic signals that can assume two different values, e.g. a high value (corresponding to a power supply voltage Vdd), conventionally associated with a "1" logic value, and a low value (corresponding to the ground voltage), conventionally associated with a "0" logic value. Moreover, the complementary input terminal *D1 is adapted to receive a logic signal that is complementary to the one received by the input terminal D1. The flip-flop F1 further includes an output terminal Q1 and a complementary output terminal *Q1, providing output logic signals complementary to each other. Finally, the flip-flop F1 includes a clock terminal C1 and a complementary clock terminal *C1. The clock terminal C1 receives the clock signal ck0, and the complementary clock terminal *C1 receives the clock signal ck180.

The output terminal Q1 is connected to an input terminal D2 of the flip-flop F2, and the complementary output terminal *Q1 is connected to a complementary input terminal *D2 of the flip-flop F2 (moreover, the output terminal Q1 of the flip-flop F1 provides the divided signal Vd). A clock terminal C2 of the flip-flop F2 receives the clock signal ck240, and a complementary clock terminal *C2 receives the clock signal ck60. The flip-flop F2 further includes an output terminal Q2 connected to an input terminal D3 of the flip-flop F3 and a complementary output terminal *Q2 connected to a complementary input terminal *D3 of the flip-flop F3. A clock terminal C3 of the flip-flop F3 receives the clock signal ck120, and a complementary clock terminal *C3 receives the clock signal ck300. The flip-flop F3 further includes an output terminal Q3 connected to the complementary input terminal *D1 of the flip-flop F1 and a complementary output terminal *Q3 connected to the input terminal D1 of the flip-flop F1.

To explain the functioning of the high frequency divider 108, in Figure 4 (to be read together with Figure 3) is illustrated a simplified (i.e., not considering any delaying) time diagram showing the temporal evolutions of a plurality of signals generated by the flip-flops F1, F2, F3 with respect to the temporal variations of the clock signals ck0, ck120 and ck240; the remaining clock signals ck180, ck300 ck60 (that are complementary to the previous ones) are neglected for the sake of simplicity. More particularly, the Figure 4 illustrates the signals received and/or provided by the terminals of the flip-flops F1-F3. Such signals are denoted in the figure with the same references as the corresponding terminals.

Let us assume now that at the time instant t0 the logic values of the signals Q1, Q2, Q3, D2 and D3 are all equal to "0", and the logic value of the signal D1 is equal to "1". At the time instant t1, the signal Q1, which is "sensible" to the leading edges of the clock signal ck0, switches to the "1" value (because the signal D1 is at the "1" value); as a consequence, the signal Q1 (and the signal D2) remains at the "1" value until the signal D1 has the "0" value in correspondence of a leading edge of the clock signal ck0. The signal Q2, which is "sensible" to the leading edges of the clock signal ck240, switches to the "1" value at the time instant t5; even in this case, the signal Q2 (and the signal D3) remains at the "1" value until the signal D2 has the "0" value in correspondence of a leading edge of the clock signal ck240. The signal Q3, which is "sensible" to the leading edges of the clock signal ck120, switches to the "1" value at the time instant t9, and remains at this value until the signal D3 has the "0" value in correspondence of a leading edge of the clock signal ck120. The signal D1 is equal to the complement of the signal Q3, that is, is equal to the signal *Q3. As a consequence, the signal D1 remains at the "1" value until the signal Q3 has the "1" value in correspondence of the leading edge of the clock signal ck120 (time instant t9). Thus, at the time interval t13 the signal Q1 (and so, the signal D2) switches to the "0" value, and so on.

As can be seen by the temporal evolutions of the signals showed in the Figure 4, the signals Q1, Q2 and Q3 (and then also the divided signal Vd) are periodic signals of frequency equal to Fo/4 (Fo is the frequency of the three clock signals ck0, ck120 and ck240). The signal Q1 is delayed with respect to the signal Q2. More particularly the two signals have a phase difference ΦΦ equal to the one of the corresponding pair of clock signals ck0-ck240 and ck180-ck60, that is:

$$\Delta\Phi \; = \; \frac{2}{3} \, 2\pi \, .$$

At the same way, the signal Q2 is delayed with respect to the signal Q3, (phase difference equal to ΦΦ), and the signal Q3 is delayed respect to the signal Q1 (phase difference equal to ΦΦ).

The synthesis of such signals of frequency equal to Fo/4 (Q1, Q2 and Q3) from signals of frequency equal to F0 (ck0-ck300) is possible according to the crossed-closed-loop configuration of the high frequency divider 108. In fact, observing Figure 3 and Figure 4, the propagation of a signal through the loop engages six "events" before returning to its starting condition. For example, the propagation of a leading edge of the signal D1 tracks the following "pathway": from D1 to Q1=D2 (event one), from D2 to Q2=D3 (event two), from D3 to Q3=*D1 (event three), from *D1 to *Q1=*D2 (event four), from *D2 to *Q2=*D3 (event five), and from *D3 to *Q3=D1 (event six). Thanks to the fact that the period of each clock signal has a duration of 1/Fo, and thanks to the mutual phase difference ΦΦ between the clock signals of adjacent flip-flops, the duration in time of these six events coincides with four periods of a single clock signal:

$$6 \, \frac{2}{3 \mathbf{Fo}} \; = \; \frac{4}{\mathbf{Fo}} \, .$$

More generally, it is necessary to complete the loop twice before returning to the same condition (because of its crossed-configuration). Denoting with M the number of stages of the frequency divider (M=3 in the example at issue), this requires 2M of the above-described events. Each event has a duration equal to the time interval (ΦT) between the corresponding clock signals ck0-ck300. In order to ensure the periodic behaviour of the frequency divider, such time interval ΦT must by a multiple of the period To=1/Fo divided by the number of stages M, that is (denoting with K a predefined factor):

$$\Delta \mathbf{T} = \frac{\mathbf{K}}{\mathbf{M}} \mathbf{To} \qquad (\text{i.e.}, \quad \Delta\phi = \frac{\mathbf{K}}{\mathbf{M}} 2\pi )$$

(with K=2 in the example at issue). Therefore, the period (T) of the signals Q1-Q3 will be:

$$\mathbf{T} = 2\mathbf{M} \frac{\mathbf{K}}{\mathbf{M}} \mathbf{To} = 2\mathbf{KTo}$$

(with T=2·2·To=4To in this example).

Although the present invention has been described above with a certain degree of particularity with reference to preferred embodiment(s) thereof, it should be understood that various changes in the form and details as well as other embodiments are possible. Particularly, it is expressly intended that all combinations of those elements and/or method steps that substantially perform the same function in the same way to achieve the same results are within the scope of the invention.

For example, similar considerations apply if the PLL has a different structure or includes equivalent components. In any case, the numerical examples described above (for example, with reference to the dividing ratio, the frequencies at stake, and the like) are merely illustrative and must not be interpreted in a limitative manner. Alternatively, the frequency divider can be based on a different number of phases. Likewise, the desired clock signals can be taken at the output of any other stage of the frequency divider.

In any case, equivalent flip-flops can be used to implement the stages of the frequency divider.

Moreover, it will be apparent to those skilled in the art that the additional features providing further advantages are not essential for carrying out the invention, and may be omitted or replaced with different features.

For example, any other phase differences among the clock signals is possible (with the corresponding dividing ratio that changes accordingly).

The principles of the invention should not be limited to the described frequency divider with three stages (with the same solution that can be applied to any other number of stages).

Likewise, the factor defining the phase-difference can be different from 2 in alternative embodiments of the invention.

Moreover, the cross-connection within the loop of the frequency divider may be replaced by equivalent configurations, as a pair of digital inverters, a fully differential amplifier, or multiple cross-connections.

In any case, the frequency divider according to the present invention lends itself to be implemented even replacing the flip-flops with equivalent delaying blocks.

Moreover, a single-ended implementation of the proposed frequency divider is within the scope of the invention.

Even though in the preceding description reference has been made to the use of the proposed solution in a PLL, this is not to be intended as a limitation; indeed, the frequency divider of the invention can also be used in connection with any multiphase oscillator circuits.

In addition, an implementation of the PLL with a single frequency divider is not excluded.

At the end, it is also possible to use more clock signals generated by the frequency divider (up to all the available ones).

**Claims**

1. A frequency divider circuit (108) for obtaining, from a plurality of first signals (ck0,ck60,ck120,ck180,ck240,ck300) having a first frequency (Fo) and being out-of-phase to each other, at least one second signal (Vd) having a second frequency (Fd) equal to a fraction of the first frequency, wherein the frequency divider circuit includes a delaying block (F1,F2,F3) for each first signal, the delaying blocks being series-connected in a closed loop and having a signal input (D1,*D1; D2,*D2; D3,*D3), a signal output (Q1,*Q1; Q2,*Q2; Q3,*Q3) connected to the signal input of a next delaying block in the closed loop, and a clock input (C1,*C1; C2,*C2; C3,*C3) for receiving the corresponding first signal, wherein each second signal is taken from the signal output of a corresponding delaying block.

2. The frequency divider circuit (108) according to claim 1, wherein a phase difference between the first signals of each pair of adjacent delaying blocks (F1,F2,F3) in the closed loop is equal to 2Φ radians divided by a number of the delaying blocks and multiplied by a predetermined factor, said fraction being equal to twice said factor.

3. The frequency divider circuit (108) according to claim 1 or 2, wherein the delaying blocks (F1,F2,F3) consist of three delaying blocks.

4. The frequency divider circuit (108) according to claim 2 or 3, wherein said factor is equal to two.

5. The frequency divider circuit (108) according to any claim from 1 to 4, wherein each delaying block (F1,F2,F3) includes a master-slave flip-flop, the signal input (D1,*D1; D2,*D2; D3,*D3) including a main signal input terminal (D1;D2;D3), the signal output (Q1,*Q1; Q2,*Q2; Q3,*Q3) including a main signal output (Q1;Q2;Q3) terminal and a complementary signal output terminal (*Q1;*Q2;*Q3), and wherein a chosen one of the delaying blocks has the complementary signal output terminal connected to the main signal input terminal of the next delaying block, and each of the others delaying blocks has the main signal output terminal connected to the main signal input terminal of the next delaying block.

6. The frequency divider circuit (108) according to claim 5, wherein each first signal consists of a main first signal and a complementary first signal in phase opposition, for each flip-flop the signal input (D1,*D1; D2,*D2; D3,*D3) further including a complementary signal input terminal (*D1;*D2;*D3), and the clock input (C1,*C1; C2,*C2; C3,*C3) including a main clock terminal (C1;C2;C3) and a complementary clock terminal (*C1;*C2;*C3), and wherein the chosen delaying block has the main signal output terminal connected to the complementary signal input terminal of the next delaying block, and each of the others delaying blocks has the complementary signal output terminal connected to the complementary signal input terminal of the next delaying block, the main clock terminal and the complementary clock terminal of each flip-flop receiving the corresponding main first signal and complementary first signal, respectively.

7. A phase locked loop circuit (100) including:

   a frequency divider circuit (108) according to any claim from 1 to 6;
   a multi-phase voltage controlled oscillator circuit (125) for providing the first signals (ck0,ck60,ck120,ck180,ck240,ck300) to the frequency divider circuit in response to a control signal (Vc); and
   a phase detector circuit (115;120) for providing the control signal to the multi-phase voltage controlled oscillator circuit according to a further phase difference between the at least one second signal (Vd) and a reference signal (Vr).

8. The phase locked loop circuit (100) according to claim 7, further including a further frequency divider circuit (110) for dividing the frequency of the at least one second signal (Vd).

9. The phase locked loop circuit (100) according to claim 7 or 8, wherein the at least one second signal (Vd) consists of a single second signal.

10. A frequency divider method for obtaining, from a plurality of first signals having a first frequency and being out-of-phase to each other, at least one second signal having a second frequency equal to a fraction of the first frequency, wherein the method includes the steps of:

   providing a delaying block for each first signal, the delaying blocks being series-connected in a closed loop and having a signal input, a signal output connected to the signal input of a next delaying block in the closed loop, and a clock input;
   applying each first signal to the clock input of the corresponding delaying block; and
   taking each second signal from the signal output of a corresponding delaying block.

F1

F2

F3

| D1 | Q1 |
| *D1 | *Q1 |
| C1 | *C1 |

| D2 | Q2 |
| *D2 | *Q2 |
| C2 | *C2 |

| D3 | Q3 |
| *D3 | *Q3 |
| C3 | *C3 |

ck0    ck180        Vd    ck240  ck60        ck120   ck300

108

EP 1 693 965 A1

t00 t02 t04 t06 t08 t10 t12 t14 t16 t18 t20 t22 t24 t26 t28 t30
t01 t03 t05 t07 t09 t11 t13 t15 t17 t19 t21 t23 t25 t27 t29 t31

ck0

ck120

ck240

D1

Q1

D2

Q2

D3

Q3

*Q3

**European Patent Office**

**EUROPEAN SEARCH REPORT**

Application Number

EP 05 10 1333

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 163 182 A (CANARD ET AL) 19 December 2000 (2000-12-19) * column 4, line 15 - column 8, line 43; figures * | 1,2,4-10 | H03K23/42 H03K23/54 H03L7/183 H03L7/099 |
| X | EP 0 270 191 A (PHILIPS ELECTRONIC AND ASSOCIATED INDUSTRIES LIMITED; N.V. PHILIPS' GL) 8 June 1988 (1988-06-08) * column 3, line 50 - column 4, line 12; figures 5,6 * | 1,2,5,10 | |
| X | US 3 862 401 A (ZIBIN ET AL) 21 January 1975 (1975-01-21) * column 2, line 35 - column 3, line 2 * * column 4, line 23 - column 6, line 50; figures 1,3 * | 1,10 | |
| A | PAUL HOROWITZ AND WINFIELD HILL: "THE ART OF ELECTRONICS" 1989, PRESS SYNDICATE OF THE UNIVERSITY OF CAMBRIDGE , CAMBRIDGE, UK , XP002341465 * page 508, column 1, line 10 - page 509, column 1, line 21; figure 8.52 * | 5,6 | TECHNICAL FIELDS SEARCHED (Int.Cl.7) H03K H03L |

The present search report has been drawn up for all claims

| Place of search | Date of completion of the search | Examiner |
|---|---|---|
| The Hague | 29 August 2005 | Balbinot, H |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 05 10 1333

This annex lists the patent family members relating to the patent documents cited in the above-mentioned European search report.
The members are as contained in the European Patent Office EDP file on
The European Patent Office is in no way liable for these particulars which are merely given for the purpose of information.

29-08-2005

| Patent document cited in search report | | Publication date | Patent family member(s) | | Publication date |
|---|---|---|---|---|---|
| US 6163182 | A | 19-12-2000 | DE | 69820326 D1 | 22-01-2004 |
| | | | DE | 69820326 T2 | 18-11-2004 |
| | | | EP | 0872959 A1 | 21-10-1998 |
| | | | JP | 11008550 A | 12-01-1999 |
| EP 0270191 | A | 08-06-1988 | GB | 2198603 A | 15-06-1988 |
| | | | EP | 0270191 A2 | 08-06-1988 |
| | | | JP | 63301624 A | 08-12-1988 |
| | | | US | 4845727 A | 04-07-1989 |
| US 3862401 | A | 21-01-1975 | DE | 2308607 A1 | 26-09-1974 |
| | | | FR | 2219577 A1 | 20-09-1974 |
| | | | GB | 1405713 A | 10-09-1975 |

EPO FORM P0459

For more details about this annex : see Official Journal of the European Patent Office, No. 12/82